# EUROPEAN PATENT SPECIFICATION

(11) **EP 3 944 436 B1**
(45) Date of publication and mention of the grant of the patent: **09.04.2025**
(21) Application number: 21186893.0
(22) Date of filing: 21.07.2021
(51) Int. Cl.: H02G 1/12

(54) **REMOVAL DEVICE OF CABLE FOIL**
ENTFERNUNGSVORRICHTUNG VON KABELFOLIE
DISPOSITIF DE RETRAIT DE FEUILLE DE CÂBLE

(30) Priority: 27.07.2020 KR 20200093001
(43) Date of publication of application: 26.01.2022
(73) Proprietor: Jeilfa Co., Ltd., Gyeonggi-do 16643 (KR)
(72) Inventor: Go, Wang Sik, 16684 Suwon-si, Gyeonggi-do (KR); Lee, Jae Hoon, 16271 Suwon-si, Gyeonggi-do (KR)
(74) Representative: Nordic Patent Service A/S

(56) References cited:
- JP-A- 2006 149 082
- JP-B2- 3 844 831
- KR-A- 20120 011 906
- US-A- 4 942 789
- US-A1- 2014 174 267

## Description

### BACKGROUND OF THE DISCLOSURE

### Technical Field

The present disclosure relates to a removal device of cable foil according to the preamble of claim 1, and in particular, to a removal device of cable foil, in which an outer insulating member and foil of an electric wire (including a cable) are cut by a foil cutting unit and the cut foil is stripped by a foil stripping unit, thus reducing working time for removing the foil and enabling the outer insulating member and foil of the electric wire to be uniformly removed.

### Background Art

Generally, an electric wire collectively refers to a line used to send power or electric signals.

The electric wire is formed such that at least one metal wire is surrounded by an insulating member, and an outer insulating member is formed to surround the outside of the insulating member again. Here, metal foil for shielding EMI is formed between the insulating member surrounding the metal wire and the outer insulating member surrounding the outside of the insulating member.

In order to use the electric wire configured as such, after the outer insulating member and the metal foil are removed from the electric wire, the metal wire should be coupled to metal wire of another electric wire or should be connected to a power terminal of a power source.

Conventionally, since the outer insulating member and the metal foil are removed using the manpower of a worker, a working time increases and it is difficult to uniformly remove the outer insulating member and the metal foil.

JP 3 844 831 B2 shows a device according to the preamble of claim 1 for stripping a sheathed coaxial cable which has transmission arrangement rotating a disc-shaped cutter, the disc-shaped cutter going round a coaxial cable while rotating.

JP 2006 149082 A shows a device for stripping having a cutting member and two centralizers are disposed at a roughly equal angle along a circumferential direction of an outer periphery surface of a wire. A suction pipe opening is provided, adjacent to the cutting position of the cutting member, such that coating material which is cut by the cutting member is removed by being sucked into the suction pipe

US 4 942 789 A shows a device for stripping sheathing from wire at controllable depth, the apparatus comprising a rotating spindle on the carriage and a structure including a blade or blades on the spindle and rotatable thereby to rotatably cut into the wire sheathing and a control on the spindle to control the depth of cutting of the blade or blades into the sheathing, as the spindle rotates, and a drive operatively connected with the carriage to carry the blade or blades to selected positions along the wire and at which the blade or blades then cut into the sheathing, to controlled depth, the carriage being retractable to pull a cut plug of the sheathing endwise off the wire.

KR 2012 0011906 A shows an automatic stripping device cutting an insulated coating, a shielding layer, and an insulating layer of an end part of a cable. The device comprises a processing part for stripping the cable and a cable transfer part which transfers the cable by being interlocked with the processing part. The processing part includes a cutting part, a first peeling part which exposes the insulating layer and the shielding layer, and a second peeling part which exposes a core line.

US 2014/174267 A1 shows a device for removing a screen from a cable including at least one conductor, screen, and outer insulation.

### SUMMARY

### Technical Problem

An aspect of the present disclosure provides a removal device of cable foil, in which an outer insulating member and foil of an electric wire are cut by a foil cutting unit and the cut foil is stripped by a foil stripping unit, thus reducing working time for removing the foil and enabling the outer insulating member and foil of the electric wire to be uniformly removed.

### Technical Solution

The removal device of cable foil according to claim 1 of includes a fixing member configured to fix an electric wire; a foil cutting unit disposed adjacent to the fixing member to cut foil of the electric wire fixed by the fixing member; and a foil stripping unit configured to strip the foil of the electric wire, which is cut by the foil cutting unit, from the electric wire.

The foil cutting unit includes a first rotating member rotatably disposed adjacent to the fixing member to be rotated by a connected first rotating shaft; a first rotation motor connected to the first rotating shaft to rotate the first rotating shaft; a pair of cutting blades slidably installed on the first rotating member so that the blades come into contact with or are released from the electric wire by a sliding movement; and a distance adjustment means configured to slide the cutting blades and thereby adjust a distance between the pair of cutting blades.

The foil stripping unit includes a second rotating member rotatably disposed inside the first rotating member to be rotated by a connected second rotating shaft; a second rotation motor connected to the second rotating shaft to rotate the second rotating shaft; and a stripping member installed on the second rotating member to come into contact with the outer surface of the electric wire.

The stripping member is rotatably installed on the second rotating member, and further includes a third rotating shaft connected to the stripping member; and a third rotation motor connected to the third rotating shaft to rotate the third rotating shaft.

The distance adjustment means may include a sliding member formed to surround the first rotating shaft, installed to slide along the first rotating shaft, and tapered on an outer surface thereof towards the first rotating member such that a diameter thereof is reduced towards the first rotating member; and a distance adjustment member installed on the first rotating member such that a central portion thereof is rotatable, installed such that a first side thereof is connected to each cutting blade, and installed such that a second side thereof is in contact with the tapered outer surface of the sliding member.

The removal device may further include a slide block installed to be connected to the sliding member; a slide driver connected to the slide block to slide the slide block; and a contact wheel rotatably installed on the second side of the distance adjustment member to come into contact with the tapered outer surface of the sliding member.

The second rotating member and the stripping member may be rotated in opposite directions.

### ADVANTAGEOUS EFFECTS

As described above, the removal device of the cable foil according to the present disclosure may cut the outer insulating member and foil of the electric wire by the foil cutting unit and strip the cut foil by the foil stripping unit, thus reducing working time for removing the foil and enabling the outer insulating member and foil of the electric wire to be uniformly removed.

### BRIEF DESCRIPTION OF THE DRAWINGS

FIG. 1 is a perspective view illustrating a removal device of cable foil according to the present disclosure.
FIG. 2 is a front view illustrating the removal device of the cable foil according to the present disclosure.
FIG. 3 is a side sectional view illustrating the removal device of the cable foil according to the present disclosure.
FIG. 4 is a partially enlarged perspective view illustrating the removal device of the cable foil according to the present disclosure.
FIGS. 5 to 7 are diagrams illustrating an operating state of the removal device of the cable foil according to the present disclosure.

### DESCRIPTION OF EXEMPLARY EMBODIMENTS

Specific structural or functional descriptions in the embodiments of the present disclosure disclosed in this specification or application are only for description of the embodiments of the present disclosure. Embodiments of the present disclosure may be implemented in various forms, and the descriptions should not be construed as being limited to the embodiments described in the specification or application.

Since the present disclosure may be embodied in many different forms, particular embodiments will be illustrated in the drawings and be described in detail herein. However, it is to be understood that the present description is not intended to limit the present disclosure to those exemplary embodiments, and the present disclosure is intended to cover not only the exemplary embodiments, but also various alternatives, modifications, equivalents and other embodiments that fall within the spirit and scope of the present disclosure.

It will be understood that, although the terms "first", "second", etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

It will be understood that when an element is referred to as being "coupled" or "connected" to another element, it can be directly coupled or connected to the other element or intervening elements may be present therebetween. In contrast, it should be understood that when an element is referred to as being "directly coupled" or "directly connected" to another element, there are no intervening elements present. Other expressions that explain the relationship between elements, such as "between", "directly between", "adjacent to" or "directly adjacent to" should be construed in the same way.

The terminology used herein is for the purpose of describing particular embodiments only and is not intended to be limiting. In the present disclosure, the singular forms are intended to include the plural forms as well, unless the context clearly indicates otherwise. It will be further understood that the terms "comprise", "include", "have", etc. when used in this specification, specify the presence of stated features, integers, steps, operations, elements, components, and/or combinations of them but do not preclude the presence or addition of one or more other features, integers, steps, operations, elements, components, and/or combinations thereof.

Unless otherwise defined, all terms including technical and scientific terms used herein have the same meaning as commonly understood by one of ordinary skill in the art to which the present disclosure belongs. It will be further understood that terms used herein should be interpreted as having a meaning that is consistent with their meaning in the context of this specification and the relevant art and will not be interpreted in an idealized or overly formal sense unless expressly so defined herein.

Hereinafter, a removal device of cable foil according to a preferred embodiment of the present disclosure will be described.

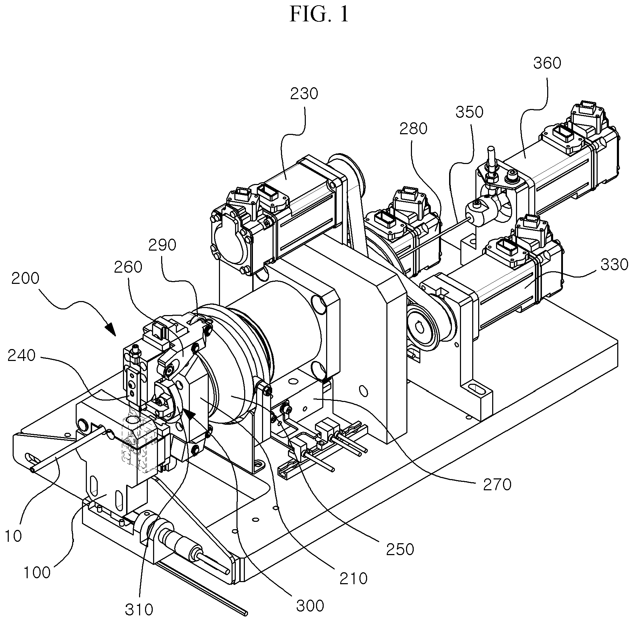

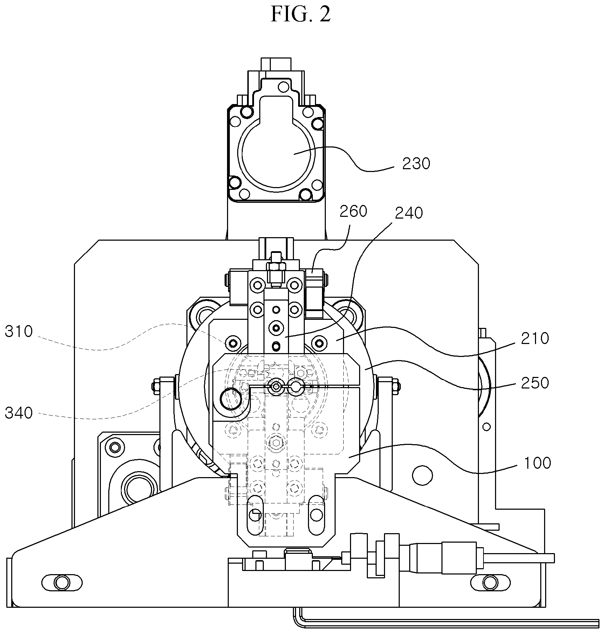

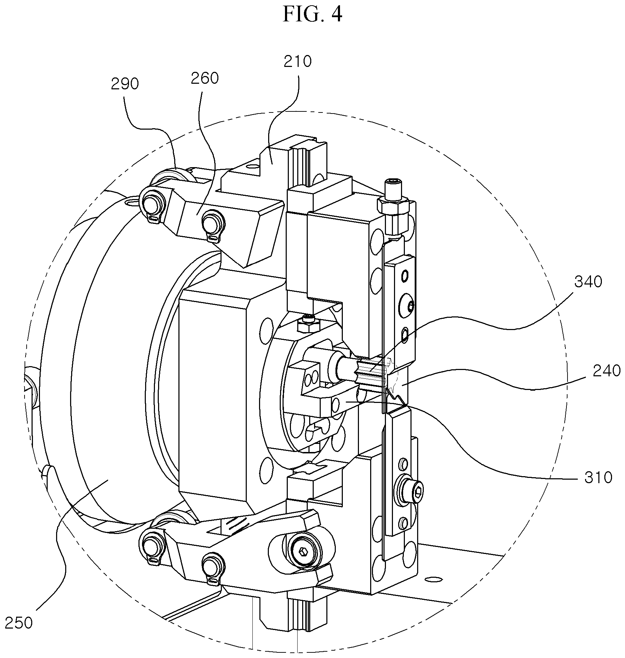

As shown in FIGS. 1 to 4, the removal device of the cable foil according to the present disclosure includes a fixing member 100 configured to fix an electric wire 10, a foil cutting unit 200 which is disposed adjacent to the fixing member 100 to cut foil of the electric wire 10 fixed by the fixing member 100, and a foil stripping unit 300 configured to strip the foil of the electric wire 10, which is cut by the foil cutting unit 200, from the electric wire 10.

First, the fixing member 100 is a member formed in the shape of an approximately rectangular box, and is formed such that upper and lower portions thereof are separated from each other. The upper portion thereof is rotatably coupled to the lower portion in the form of a hinge. Here, a fixing hole having a diameter corresponding to that of the electric wire 10 is formed at a portion where the upper and lower portions of the fixing member 100 come into contact with each other. Thus, as the electric wire 10 is introduced into the fixing hole, the fixing member 100 fixes the electric wire 10. An operation where the fixing member 100 fixes the electric wire 10 is as follows: after the upper portion of the fixing member 100 is rotated upwards, the electric wire 10 is positioned in the fixing hole formed in the lower portion of the fixing member 100 and then the upper portion of the fixing member 100 is rotated downwards, so the electric wire 10 is fixed to the fixing member 100. In this case, a portion of the electric wire 10 from which the foil is to be stripped is fixed to be positioned on the foil cutting unit 200 and the foil stripping unit 300.

Meanwhile, the foil cutting unit 200 includes a first rotating member 210 which is rotatably disposed adjacent to the fixing member 100 to be rotated by a connected first rotating shaft 220, a first rotation motor 230 which is connected to the first rotating shaft 220 to rotate the first rotating shaft 220, a pair of cutting blades 240 which are slidably installed on the first rotating member 210 so that the blades come into contact with or are released from the electric wire 10 by a sliding movement, and a distance adjustment means which slides the cutting blades 240 to adjust a distance between the pair of cutting blades 240.

The first rotating member 210 is a rectangular structure in which a hollow portion is formed and which has a predetermined thickness, and is rotatably installed adjacent to the fixing member 100 such that a first side thereof faces the fixing member 100. Here, a second side of the first rotating member 210 is connected to the first rotating shaft 220, and the first rotating shaft 220 is connected to the first rotation motor 230, so the first rotating member 210 is rotated by driving the first rotation motor 230. In this regard, the first rotating shaft 220 and the first rotation motor 230 are installed to be connected to each other by a belt pulley. However, without being limited thereto, the first rotating shaft 220 and the first rotation motor 230 may be connected in a shaft coupling manner.

Furthermore, extension portions are provided on both sides of the first rotating member 210 to extend outwards from the first rotating member 210, and a pair of cutting blades 240 is installed on each extension portion. The cutting blade 240 is formed of a plate-shaped metal having a predetermined thickness, and has on a first end thereof a cutting edge configured to cut an outer insulating member and the foil of the electric wire 10. The cutting blade 240 is slidably installed on each extension portion of the first rotating member 210. Thus, when a distance between the cutting blades 240 is narrow, the cutting edge of the cutting blade 240 comes into contact with the outer surface of the electric wire 10. When a distance between the cutting blades 240 is wide, the cutting edge of the cutting blade 240 comes away from the outer surface of the electric wire 10. If the first rotating member 210 is rotated in a state where the cutting edge of the cutting blade 240 configured as such comes into contact with the outer surface of the electric wire 10, the cutting blade 240 is rotated along with the first rotating member 210, thereby cutting the outer insulating member and the foil of the electric wire 10.

Furthermore, the distance adjustment means includes a sliding member 250 which is formed to surround the first rotating shaft 220, is installed to slide along the first rotating shaft 220, and is tapered on an outer surface thereof towards the first rotating member 210 such that a diameter thereof is reduced towards the first rotating member 210, a distance adjustment member 260 which is installed on the first rotating member 210 such that a central portion thereof is rotatable, is installed such that a first side thereof is connected to each cutting blade 240, and is installed such that a second side thereof is in contact with the tapered outer surface of the sliding member 250, a slide block 270 which is installed to be connected to the sliding member 250, a slide driver 280 which is connected to the slide block 270 to slide the slide block 270, and a contact wheel 290 which is rotatably installed on the second side of the distance adjustment member 260 to come into contact with the tapered outer surface of the sliding member 250.

The sliding member 250 is a conical member in which a hollow portion is formed, and the first rotating shaft 220 is installed to be fitted into the hollow portion of the sliding member 250. Here, the sliding member 250 is disposed such that a vertex thereof faces the first rotating member 210. Thus, the outer surface thereof is tapered towards the first rotating member 210. The slide block 270 is connected to the lower portion of the sliding member 250, and the slide block 270 is connected to the slide driver 280, so the slide block 270 slides by the driving of the slide driver 280. Thereby, the sliding member 250 connected to the slide block 270 slides along the first rotating shaft 220.

A pair of distance adjustment members 260 is provided, so the central portion of each distance adjustment member 260 is rotatably installed on each extension portion of the first rotating member 210. Further, the first side of each distance adjustment member 260 is connected to each cutting blade 240, and the second side thereof is installed to be in contact with the tapered outer surface of the sliding member 250. Here, the contact wheel 290 which is rotatably installed on the second side of each distance adjustment member 260 is provided, so the contact wheel 290 comes into contact with the tapered outer surface of the sliding member 250.

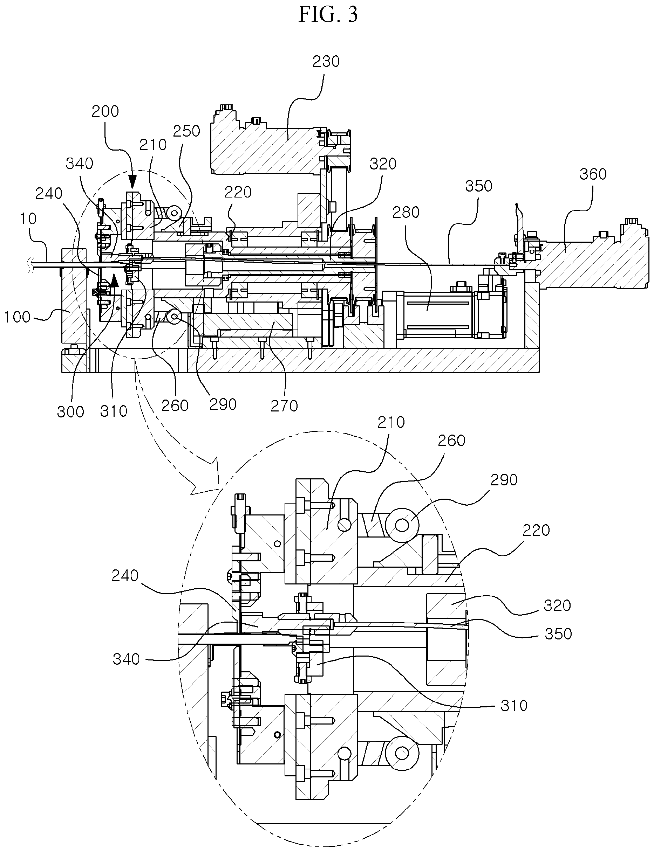

An operation of the distance adjustment means configured as such will be described with reference to FIGS. 3 to 5. The slide block 270 is slid by the operation of the slide driver 280, and thus the sliding member 250 connected to the slide block 270 slides along the first rotating shaft 220. If the slide driver 280 is operated to move the sliding member 250 to the left of FIG. 3, the second side of the distance adjustment member 260 moves upwards along the outer surface of the sliding member 250 by the movement of the contact wheel 290. Thereby, the first side of the distance adjustment member 260 is moved downwards, so the cutting blade 240 connected to the first side of the distance adjustment member 260 is moved downwards. This describes the distance adjustment member 260 and the cutting blade 240 located on the upper side of FIG. 3, and the distance adjustment member 260 and the cutting blade 240 located on the lower side of FIG. 3 are moved in a direction opposite to that of the above description. As such, the cutting blade 240 is moved up and down by the distance adjustment means, thus adjusting the distance between the cutting blades 240. By this operation, the cutting edge of the cutting blade 240 comes into contact with or is released from the outer surface of the electric wire 10.

Meanwhile, the foil stripping unit 300 includes a second rotating member 310 which is rotatably disposed inside the first rotating member 210 to be rotated by a connected second rotating shaft 320, a second rotation motor 330 which is connected to the second rotating shaft 320 to rotate the second rotating shaft 320, a stripping member 340 which is rotatably installed on the second rotating member 310 to come into contact with the outer surface of the electric wire 10, a third rotating shaft 350 which is connected to the stripping member 340, and a third rotation motor 360 which is connected to the third rotating shaft 350 to rotate the third rotating shaft.

The second rotating member 310 is a circular plate of a predetermined diameter installed in the hollow portion of the first rotating member 210, is disposed such that a first side thereof faces the fixing member 100, and is connected at a second side thereof to the second rotating shaft 320 to be rotated by the driving of the second rotation motor 330 connected to the second rotating shaft 320. In this case, the second rotating shaft 320 may be formed to have a diameter smaller than that of the first rotating shaft 220, so the second rotating shaft may be installed in the first rotating shaft 220. Here, the second rotating shaft 320 and the second rotation motor 330 are installed to be connected to each other by the belt pulley. However, without being limited thereto, the second rotating shaft 320 and the second rotation motor 330 may be connected in a shaft coupling manner.

The stripping member 340 is a cylindrical member having a predetermined diameter, and is rotatably installed on the first side of the second rotating member 310. Here, the stripping member 340 is rotatably installed at an outer point which is distant from the center of the second rotating member 310 by a predetermined distance. This is for a side of the stripping member 340 to come into contact with the outer surface of the electric wire 10. The side of the stripping member 340 may be formed in an uneven shape.

The stripping member 340 may be connected to the third rotating shaft 350, and the third rotating shaft 350 may be connected to the third rotation motor 360, so the stripping member 340 is rotated by the rotation of the third rotation motor 360. Here, the stripping member 340 is rotated in a direction opposite to the rotating direction of the second rotating member 310.

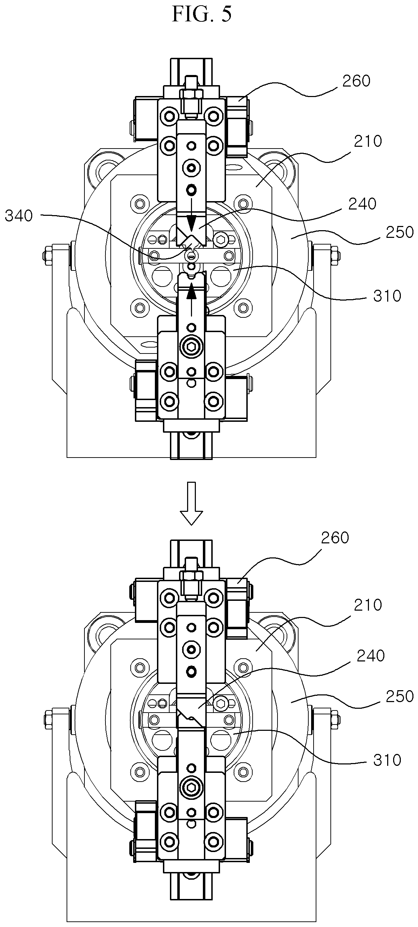

Hereinafter, an operation of the removal device of the cable foil according to the present disclosure will be described in detail with reference to FIGS. 5 to 7.

If the electric wire 10 from which the foil is to be removed is fixed by the fixing member 100, the distance between the cutting blades 240 is reduced by the distance adjustment means, so the cutting edge of the cutting blade 240 comes into contact with the outer surface of the electric wire 10 (see FIG. 5).

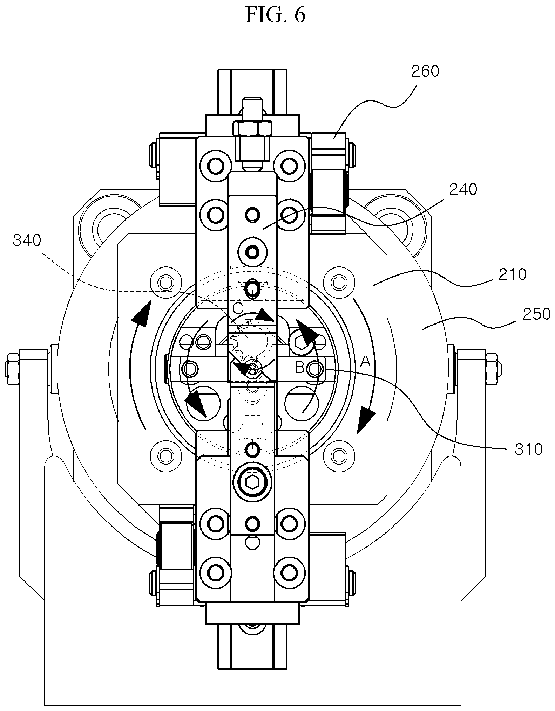

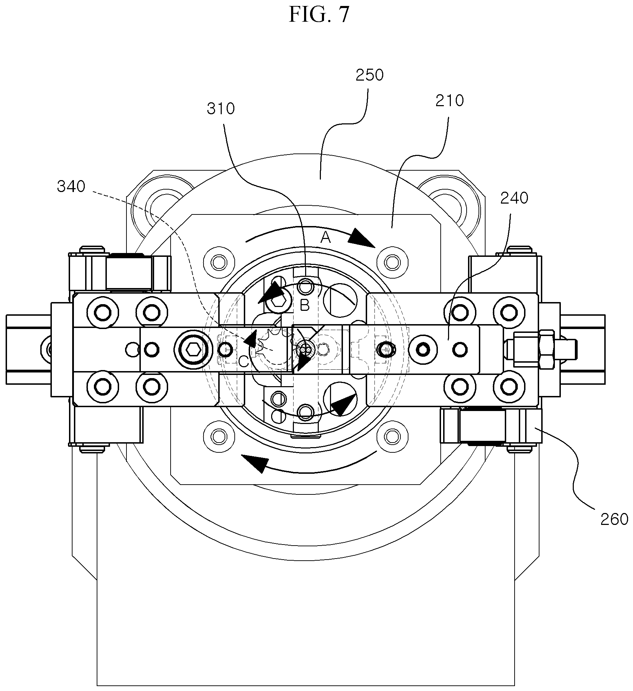

Subsequently, as shown in FIGS. 6 and 7, the first rotating member 210 is rotated in a direction shown by arrow A by the rotation of the first rotation motor 230, and thereby the cutting blade 240 installed on the first rotating member 210 is rotated. If the cutting blade 240 is rotated as such, the outer surface of the electric wire 10 coming into contact with the cutting edge of the cutting blade 240 is cut.

If the outer surface of the electric wire 10, i.e. the outer insulating member and the foil of the electric wire 10 are cut by the cutting blade 240 as such, the second rotating member 310 is rotated by the operation of the second rotation motor 330. Here, the second rotating member 310 is rotated in a direction shown by arrow B which is a direction opposite to the rotating direction of the first rotating member 210.

At the same time, the stripping member 340 is rotated in a direction shown by arrow C which is a direction opposite to the rotating direction of the second rotating member 310, so a lateral uneven portion of the stripping member 340 comes into contact with the cut outer surface of the electric wire 10 and strikes the outer surface of the electric wire 10.

As the later uneven portion of the stripping member 340 strikes the cut outer surface of the electric wire 10, the cut outer insulating member and foil of the electric wire 10 are separated and removed from the electric wire 10.

The removal device of cable foil according to the present disclosure configured and operated as described above is intended to cut the outer insulating member and foil of the electric wire 10 by the foil cutting unit 200 and strip the cut foil by the foil stripping unit 300. Thus, it is very advantageously possible to reduce working time for removing the foil and to uniformly remove the outer insulating member and foil of the electric wire.

The removal device of the cable foil according to the preferred embodiment of the present disclosure has been described.

It should be understood that the above-described embodiment is illustrative and not restrictive, and the scope of the present disclosure is defined by the appended claims rather than by the description preceding them.

**[Description of Reference Numerals]**

| | | | |
|---|---|---|---|
| 10: | electric wire | 100: | fixing member |
| 200: | foil cutting unit | 210: | first rotating member |
| 220: | first rotating shaft | 230: | first rotation motor |
| 240: | cutting blade | 250: | sliding member |
| 260: | distance adjustment member | 270: | slide block |
| 280: | slide driver | 290: | contact wheel |
| 300: | foil stripping unit | 310: | second rotating member |
| 320: | second rotating shaft | 330: | second rotation motor |
| 340: | stripping member | 350: | third rotating shaft |
| 360: | third rotation motor | | |

## Claims

1. A removal device of cable foil comprising:
a fixing member (100) configured to fix an electric wire (10);
a foil cutting unit (200) disposed adjacent to the fixing member (100) to cut foil of the electric wire (10) fixed by the fixing member (100); and
a foil stripping unit (300) configured to strip the foil of the electric wire (10), which is cut by the foil cutting unit (200), from the electric wire (10),
wherein
the foil cutting unit (200) comprises:
a first rotating member (210) rotatably disposed adjacent to the fixing member (100 to be rotated by a connected first rotating shaft (220);
a first rotation motor (230) connected to the first rotating shaft (220) to rotate the first rotating shaft (220);
a pair of cutting blades (240) slidably installed on the first rotating member (210) so that the blades come into contact with or are released from the electric wire by a sliding movement; and
distance adjustment means configured to slide the cutting blades (240) and thereby adjust a distance between the pair of cutting blades (240),
**characterised in that** the foil stripping unit (300) comprises:
a second rotating member (310) rotatably disposed inside the first rotating member (210) to be rotated by a connected second rotating shaft (320);
a second rotation motor (330) connected to the second rotating shaft (320) to rotate the second rotating shaft (320); and
a stripping member (340) installed on the second rotating member (310) to come into contact with the outer surface of the electric wire (10),
wherein
the stripping member (340) is rotatably installed on the second rotating member (310), and further comprising:
a third rotating shaft (350) connected to the stripping member (340); and
a third rotation motor (360) connected to the third rotating shaft (350) to rotate the third rotating shaft (350).

2. The removal device of claim 1, wherein
the distance adjustment means comprises:
a sliding member (250) formed to surround the first rotating shaft (220), installed to slide along the first rotating shaft (220), and tapered on an outer surface thereof towards the first rotating member (210) such that a diameter thereof is reduced towards the first rotating member (210); and
a distance adjustment member (260) installed on the first rotating member (210) such that a central portion thereof is rotatable, installed such that a first side thereof is connected to each cutting blade (240), and installed such that a second side thereof is in contact with the tapered outer surface of the sliding member (250).

3. The removal device of claim 2, further comprising:
a slide block (270) installed to be connected to the sliding member (250);
a slide driver (280) connected to the slide block (270) to slide the slide block (270); and
a contact wheel (290) rotatably installed on the second side of the distance adjustment member (260) to come into contact with the tapered outer surface of the sliding member (250).

4. The removal device of claim 1,
wherein the second rotating member (310) and the stripping member (340) are rotated in opposite directions.

## Patentansprüche

1. Entfernungsvorrichtung für Kabelfolie, umfassend:
ein Befestigungselement (100), das zum Befestigen eines elektrischen Drahts (10) konfiguriert ist;
eine Folienschneideinheit (200), die angrenzend an das Befestigungselement (100) angeordnet ist, um Folie des durch das Befestigungselement (100) befestigten elektrischen Drahts (10) zu schneiden; und
eine Folienabzieheinheit (300), die dazu konfiguriert ist, die Folie des elektrischen Drahts (10), der durch die Folienschneideinheit (200) geschnitten wird, von dem elektrischen Draht (10) abzuziehen,
wobei
die Folienschneideinheit (200) Folgendes umfasst:
ein erstes Drehelement (210), das drehbar angrenzend an das Befestigungselement (100) angeordnet ist, um durch eine verbundene erste Drehwelle (220) gedreht zu werden;
einen ersten Drehmotor (230), der mit der ersten Drehwelle (220) verbunden ist, um die erste Drehwelle (220) zu drehen;
ein Paar Schneidklingen (240), die verschiebbar an dem ersten Drehelement (210) installiert sind, sodass die Klingen durch eine Schiebebewegung mit dem elektrischen Draht in Kontakt kommen oder von diesem gelöst werden; und
Abstandseinstellungsmittel, die dazu konfiguriert sind, die Schneidklingen (240) zu verschieben und dadurch einen Abstand zwischen dem Paar Schneidklingen (240) einzustellen,
**dadurch gekennzeichnet, dass** die Folienabzieheinheit (300) Folgendes umfasst:
ein zweites Drehelement (310), das drehbar innerhalb des ersten Drehelements (210) angeordnet ist, um durch eine verbundene zweite Drehwelle (320) gedreht zu werden;
einen zweiten Drehmotor (330), der mit der zweiten Drehwelle (320) verbunden ist, um die zweite Drehwelle (320) zu drehen; und
ein Abstreifelement (340), das an dem zweiten Drehelement (310) installiert ist, um mit der Außenfläche des elektrischen Drahts (10) in Kontakt zu kommen,
wobei das Abstreifelement (340) drehbar an dem zweiten Drehelement (310) installiert ist und ferner Folgendes umfasst:
eine dritte Drehwelle (350), die mit dem Abstreifelement (340) verbunden ist; und
einen dritten Drehmotor (360), der mit der dritten Drehwelle (350) verbunden ist, um die dritte Drehwelle (350) zu drehen.

2. Entfernungsvorrichtung nach Anspruch 1, wobei
das Abstandseinstellungsmittel Folgendes umfasst:
ein Gleitelement (250), das zum Umgeben der ersten Drehwelle (220) geformt ist, zum Gleiten entlang der ersten Drehwelle (220) installiert ist und sich an einer Außenfläche davon zu dem ersten Drehelement (210) hin verjüngt, sodass ein Durchmesser davon in Richtung des ersten Drehelements (210) reduziert ist; und
ein Abstandseinstellungselement (260), das an dem ersten Drehelement (210) derart installiert ist, dass ein zentraler Abschnitt davon drehbar ist, derart installiert ist, dass eine erste Seite davon mit jeder Schneidklinge (240) verbunden ist, und derart installiert ist, dass eine zweite Seite davon in Kontakt mit der konischen Außenfläche des Gleitelements (250) steht.

3. Entfernungsvorrichtung nach Anspruch 2, ferner umfassend:
einen Gleitblock (270), der zum Verbinden mit dem Gleitelement (250) installiert ist;
einen Gleitantrieb (280), der mit dem Gleitblock (270) verbunden ist, um den Gleitblock (270) zu verschieben; und
ein Kontaktrad (290), das drehbar an der zweiten Seite des Abstandseinstellungselements (260) installiert ist, um mit der konischen Außenfläche des Gleitelements (250) in Kontakt zu kommen.

4. Entfernungsvorrichtung nach Anspruch 1,
wobei das zweite Drehelement (310) und das Abstreifelement (340) in entgegengesetzte Richtungen gedreht werden.

## Revendications

1. Dispositif de retrait de feuille de câble comprenant :
un élément de fixation (100) configuré pour fixer un fil électrique (10) ;
une unité de coupe de feuille (200) disposée de manière adjacente à l'élément de fixation (100) pour couper la feuille du fil électrique (10) fixé par l'élément de fixation (100) ; et
une unité d'enlèvement de feuille (300) configurée pour enlever la feuille du fil électrique (10), qui est coupée par l'unité de coupe de feuille (200), du fil électrique (10),
dans lequel
l'unité de coupe de feuille (200) comprend :
un premier élément rotatif (210) disposé de manière rotative et adjacente à l'élément de fixation (100) destiné à être entraîné en rotation par un premier arbre rotatif connecté (220) ;
un premier moteur de rotation (230) relié au premier arbre rotatif (220) destiné à entraîner en rotation le premier arbre rotatif (220) ; et
une paire de lames de coupe (240) installées de manière coulissante sur le premier élément rotatif (210) de sorte que les lames entrent en contact avec, ou soient libérées du, le fil électrique par un mouvement de coulissement ; et
un moyen de réglage de distance configuré pour faire coulisser les lames de coupe (240) et ainsi régler une distance entre la paire de lames de coupe (240),
**caractérisé en ce que** l'unité d'enlèvement de feuille (300) comprend :
un second élément rotatif (310) disposé de manière rotative à l'intérieur du premier élément rotatif (210) destiné à être entraîné en rotation par un deuxième arbre rotatif connecté (320) ;
un deuxième moteur de rotation (330) relié au deuxième arbre rotatif (320) destiné à entraîner en rotation le deuxième arbre rotatif (320) ; et
un élément de dénudage (340) installé sur le second élément rotatif (310) destiné à entrer en contact avec la surface extérieure du fil électrique (10),
dans lequel l'élément de dénudage (340) est installé de manière rotative sur le second élément rotatif (310), et comprenant en outre :
un troisième arbre rotatif (350) relié à l'élément de dénudage (340) ; et
un troisième moteur de rotation (360) relié au troisième arbre rotatif (350) destiné à entraîner en rotation le troisième arbre rotatif (350).

2. Dispositif de retrait selon la revendication 1, dans lequel
le moyen de réglage de distance comprend :
un élément coulissant (250) formé pour entourer le premier arbre rotatif (220), installé pour coulisser le long du premier arbre rotatif (220), et effilé sur une surface extérieure de celui-ci vers le premier élément rotatif (210) de sorte qu'un diamètre de celui-ci est réduit vers le premier élément rotatif (210) ; et
un élément de réglage de distance (260) installé sur le premier élément rotatif (210) de sorte qu'une partie centrale de celui-ci soit rotative, installé de sorte qu'un premier côté de celui-ci soit relié à chaque lame de coupe (240), et installé de sorte qu'un second côté de celui-ci soit en contact avec la surface extérieure effilée de l'élément coulissant (250).

3. Dispositif de retrait selon la revendication 2, comprenant en outre :
un bloc coulissant (270) installé pour être relié à l'élément coulissant (250) ;
un élément d'entraînement coulissant (280) relié au bloc coulissant (270) destiné à faire coulisser le bloc coulissant (270) ; et
une roue de contact (290) installée de manière rotative sur le second côté de l'élément de réglage de distance (260) destinée à entrer en contact avec la surface extérieure effilée de l'élément coulissant (250).

4. Dispositif de retrait selon la revendication 1,
dans lequel le second élément rotatif (310) et l'élément de dénudage (340) sont entraînés en rotation dans des sens opposés.
